# EUROPEAN PATENT APPLICATION

(11) **EP 0 523 957 A1**
(43) Date of publication of application: **20.01.1993**
(21) Application number: 92306441.4
(22) Date of filing: 14.07.1992
(51) Int. Cl.: G03F 7/075

(54) **Radiation-sensitive composition**

(30) Priority: 17.07.1991 JP 201178/91; 25.11.1991 JP 334546/91
(71) Applicant: JAPAN SYNTHETIC RUBBER CO., LTD., Tokyo 104 (JP)
(72) Inventor: Murata, Makoto, Yokkaichi-shi (JP); Kobayashi, Eiichi, Yokkaichi-shi (JP); Yumoto, Yoshiji, Yokkaichi-shi (JP); Miura, Takao, Yokkaichi-shi (JP)
(74) Representative: Clifford, Frederick Alan

(57) **Abstract**

A radiation-sensitive composition comprising a polymer having acid-decomposable silyl groups, a radiation-sensitive acid-forming agent and a weakly basic, nitrogen-containing compound. Said radiation-sensitive composition is suitable as a resist composition useful to superfine processing using radiations including far ultraviolet rays, X-rays and charged particle beams.

## Description

This invention relates to a radiation-sensitive composition, particularly to a radiation-sensitive composition suitable as a resist composition useful in superfine processing using a radiation including far ultraviolet rays such as excimer laser and the like, X-rays such as synchrotron radiation and the like, charged particle beams such as electron beam and the like.

In the field of fine processing, representative of which is production of integrated circuit elements, a lithographic process which enables the fine processing in an order of subhalf micron is now being developed in order to obtain a higher degree of integration.

Typical, conventional resists which have been used in the lithographic process include negative resists in which a cyclized rubber and a bisazide type sensitizer are used and positive resists in which a novolak resin and a quinonediazide type sensitizer are used. The performance of these resists is approching its limit, and it is very difficult to use the resists to form a pattern in an order of subhalf micron.

That is to say, in the above-mentioned negative resists, fine pattern lines are contacted with one another by the swelling of the resist during development, whereby the pattern is damaged. Also, when the above-mentioned positive resists are irradiated with, for example, far ultraviolet rays, their light absorption is so strong that the cross-section of the pattern becomes triangular. Also, when the resist is irradiated with a radiation having a stronger energy such as X-rays or charged particle beams, the resist is crosslinked, whereby the positive resist is changed to negative resist. When these negative and positive resists are used it is always difficult to obtain a fine pattern suitable to the lithographic process. In order to improve these points, an invention has been made which relates to a pattern-forming material comprising a silyl group-containing polymer which is useful to various radiation sources (see Japanese Patent Application Kokai No. 60-52845). However, said pattern-forming material is not necessarily satisfactory in respect of developability, pattern form, adhesiveness, lithographic process stability and the like. That is to say, there are such problems that when the pattern size is less than 1 µm, a scum is formed during development and undeveloped portions are left (poor developability), the lower side of the pattern cross-section becomes narrower than the upper side, so-called inversely tapered pattern is formed (unsatisfactory pattern form), resist pattern tends to be stripped during development (poor adhesiveness), and the sensitivity and pattern form are varied depending upon the time of from irradiation with a radiation to subsequent heating (low lithographic process stability).

The present inventors have made extensive research for the purpose of solving the above-mentioned problems of prior art to find that the problems can be solved by combining a weakly basic, nitrogen-containing compound with a conventional composition consisting of a silyl group-containing polymer and a radiation-sensitive, acid-forming agent.

An object of this invention is to provide a radiation-sensitive composition suitable as a resist composition capable of responding to various radiation sources, the resist film formed therefrom being excellent in developability, pattern form, adhesiveness, lithographic process stability and heat resistance, being not swollen with a developing solution and having high resolution degree and high sensitivity.

Other objects and advantages of this invention will become apparent from the following description.

According to this invention, there is provided a radiation-sensitive composition comprising a polymer having acid-decomposable silyl groups, a radiation-sensitive acid-forming agent and a weakly basic, nitrogen-containing compound.

In the present specification, the term "halogen atom" includes fluorine atom, chlorine atom, bromine atom and iodine atom; the term "alkyl group having 1-4 carbon atoms" includes methyl, ethyl, n-propyl, i-propyl and t-butyl; the term "alkoxy group having 1-4 carbon atoms" includes methoxy, ethoxy and t-butoxy; the term "substituted or unsubstituted aryl group having 6-20 carbon atoms" includes phenyl, tolyl, xylyl, aminophenyl, nitrophenyl, naphthyl, anthryl and pyrenyl; the term "substituted or unsubstituted aralkyl group having 7-20 carbon atoms" includes benzyl, phenacyl and anthrylmethyl; the term "alkyl group having 1-6 carbon atoms" includes the above-mentioned alkyl groups having 1-4 carbon atoms, n-pentyl, n-hexyl and cyclohexyl; the term "aminoalkyl group having 1-6 carbon atoms" includes aminoethyl, aminobutyl and aminohexyl; and the term "hydroxyalkyl group having 1-6 carbon atoms" includes hydroxyethyl and hydroxybutyl; the term "quinonediazidesulfonyl group" includes 1,2-naphthoquinonediazie-4-sulfonyl, 1,2 naphthoquinone-diazide-5-sulfonyl, 1,2-benzoquinonediazide-4-sulfonyl, 1,2-naphthoquinonediazide-6-sulfonyl, 2,1-naphthoquinonediazide-5-sulfonyl and 2,1-naphthoquinonediazide-4-sulfonyl.

The polymer having acid-decomposable silyl groups (referred to hereinafter as the silyl group-containing polymer) used in this invention includes polymers having recurring structure units represented by formula (I): 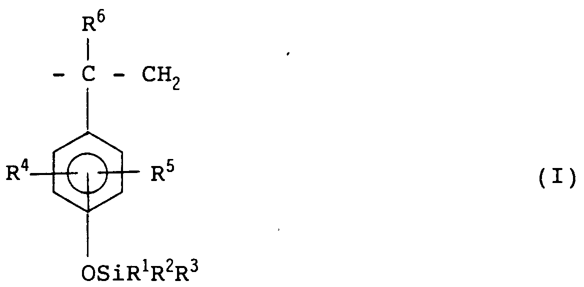
wherein R¹, R² and R³, which may be the same or different, represent hydrogen atoms, alkyl groups having 1-4 carbon atoms, phenyl groups or benzyl groups; R⁴ and R⁵, which may be the same or different, represent hydrogen atoms, halogen atoms, hydroxyl groups or alkyl groups having 1-4 carbon atoms; and R⁶ represents a hydrogen atom or a methyl group.

The recurring structure units represented by formula (I) can be formed by polymerizing monomers having the following formulas: 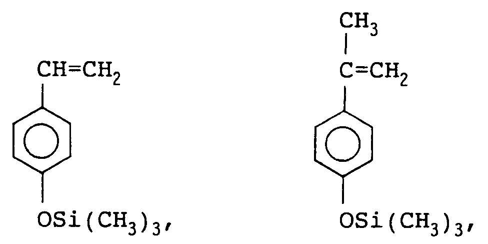 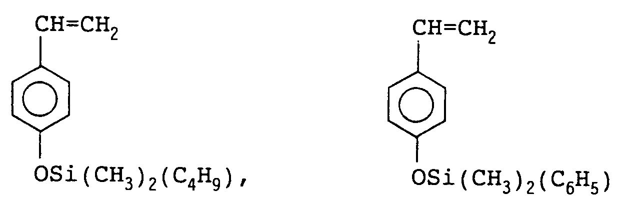
and the like.

The silyl group-containing polymer in this invention may be composed only of the recurring structure units represented by formula (I) or may comprise at least one other recurring structure unit selected from those represented by formulas (II)(a), (II)(b) and (II)(c): 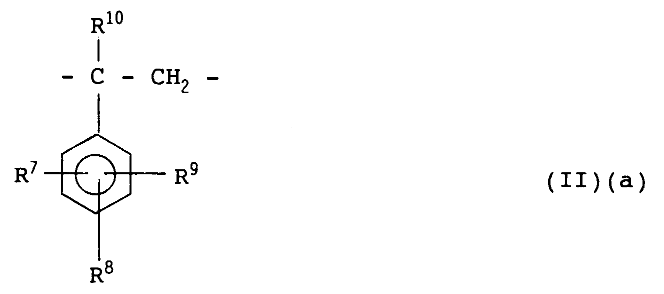 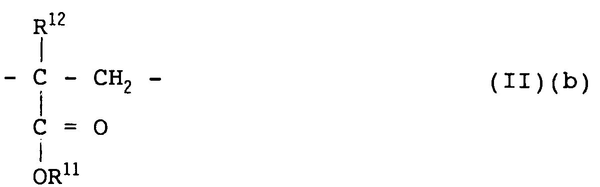 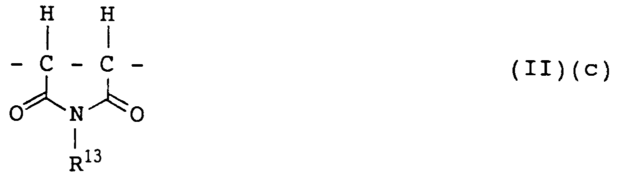
wherein R⁷, R⁸ and R⁹, which may be the same or different, represent hydrogen atoms, halogen atoms, hydroxyl groups, amino groups, alkyl groups having 1-4 carbon atoms or alkoxy groups having 1-4 carbon atoms; R¹⁰ represents a hydrogen atom or a methyl group; R¹¹ represents an alkyl group having 1-4 carbon atoms; R¹² represents a hydrogen atom or a methyl group; and R¹³ represents a hydrogen atom, a phenyl group or a hydroxyphenyl group.

The recurring structure units represented by formula (II)(a) can be formed by polymerizing monomers having the following formulas: 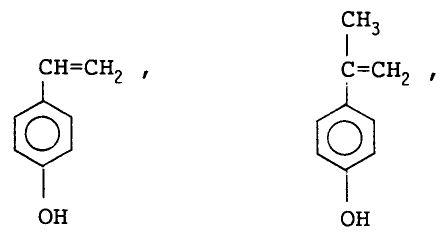 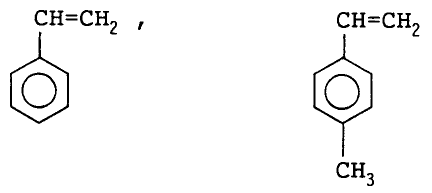
and the like.

The recurring structure units represented by formula (II)(b) can be formed by polymerizing monomers having the following formulas: 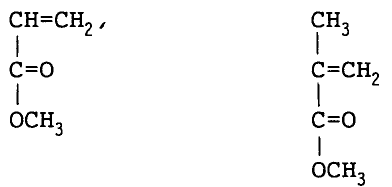
and the like.

The recurring structure units represented by formula (II)(c) can be formed by polymerizing monomers having the following formulas: 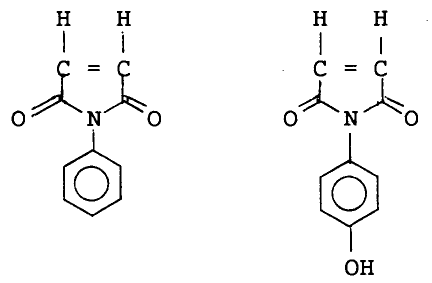
and the like.

Similarly to the recurring structure units represented by formulas (II)(a)-(II)(c), recurring structure units corresponding to the structure formed by the splitting of the vinyl group of such a monomer as maleic anhydride, vinylpyridine, vinylpyrrolidone, vinylimidazole, vinylaniline, fumaronitrile, acrylamide, acrylonitrile or the like are also appropriate.

The structure units contained along with the recurring structure units represented by formula (I) in the polymer are preferably those represented by formula (II)(a).

The content of the recurring structure unit represented by formula (I) in the silyl group-containing polymer may be varied depending upon the kind of the other recurring structure unit; however, it is preferably at least 15 mole %, more preferably at least 20 mole %. When it is less than 15 mole %, a sufficient effect is not brought about in the formation of a pattern in some cases.

The molecular weight of the silyl group-containing polymer used in this invention is preferably 10,000-300,000, more preferably 25,000-150,000 in terms of a polystyrene-reduced weight average molecular weight (referred to hereinafter as Mw) as measured by gel permeation chromatography (GPC).

The silyl group-containing polymer used in this invention can be obtained by polymerizing a corresponding silyl group-containing monomer as disclosed in Japanese patent Application Kokai No. 60-37,549 or by introducing a silyl group into a hydroxyphenylalkenyl polymer. In the latter case, the hydroxyphenylalkenyl polymer can preferably be obtained by protecting the phenolic hydroxide group of the corresponding monomer with a t-butyl group, an acetyl group, a t-butoxycarbonyl group or the like, polymerizing the protected monomer and then removing the protecting group by hydrolysis as described in "Macromolecules", 1989, 22, 509-516 or the like.

In this invention, the silyl group-containing polymer is particularly preferably a polymer having a recurring structure unit represented by formula (I) and a recurring structure unit represented by formula (III) as mentioned below, the molar ratio of the recurring structure unit represented by formula (I) to the recurring structure unit represented by formula (III) in the polymer is preferably 20-70:80-30, more preferably 25-60:75-40, and the Mw of the polymer is preferably 25,000-300,000, more preferably 25,000-150,000: 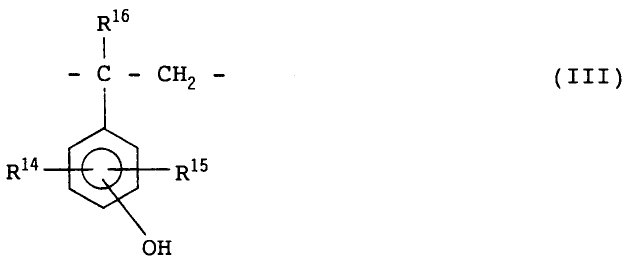
wherein R¹⁴ and R¹⁵, which may be the same or different, represent hydrogen atoms, halogen atoms or alkyl groups having 1-4 carbon atoms, and R¹⁶ represent a hydrogen atom or a methyl group.

The silyl group-containing polymers mentioned above may be used alone or in admixture.

The radiation-sensitive acid-forming agent used in this invention is a compound capable of generating an acid upon irradiation with a radiation and includes compounds as described in Japanese Patent Application Kokai Nos. 60-115,932; 60-37,549; 60-52,845; 63-292,128; and 1-293,339 and the like, for example, (1) the onium salts mentioned below, (2) the halogen-containing compounds mentioned below, (3) the o-quinonediazide compounds mentioned below, (4) the nitrobenzyl compounds mentioned below, (5) the sulfonic acid ester compounds mentioned below and (6) the sulfone compounds mentioned below:
(1) Onium salts represented by the following formulas: 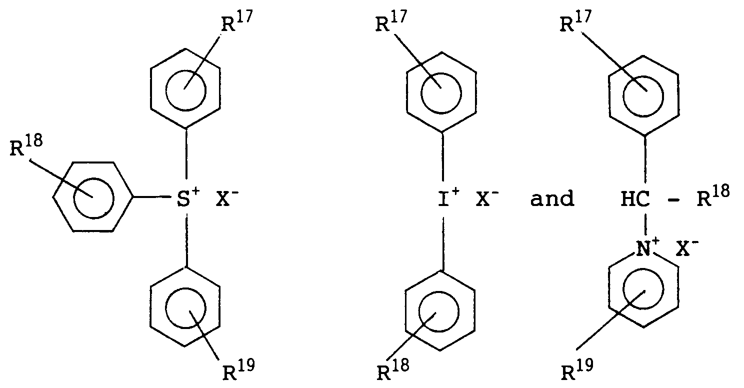 wherein R¹⁷, R¹⁸ and R¹⁹, which may be the same or different, represent hydrogen atoms, amino groups, nitro groups, cyano groups, alkyl groups having 1-4 carbon atoms or alkoxy groups having 1-4 carbon atoms, and X represents SbF₆, AsF₆, PF₆, BF₄, CF₃CO₂, ClO₄, CF₃SO₃, 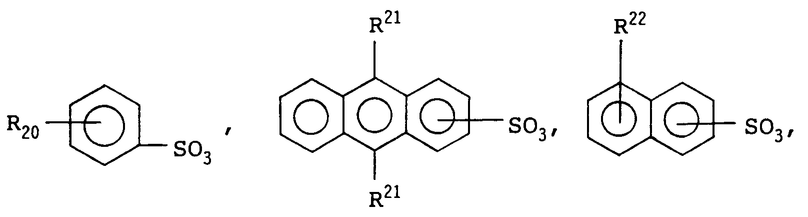 or 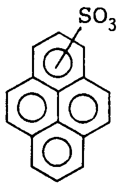 in which R²⁰ is a hydrogen atom, an amino group, an anilino group, an alkyl group having 1-4 carbon atoms or an alkoxy group having 1-4 carbon atoms, R²¹ is an alkoxy group having 1-4 carbon atoms and R²² is a hydrogen atom, an amino group, an anilino group, an alkyl group having 1-4 carbon atoms or an alkoxy group having 1-4 carbon atoms.
(2) Halogen-containing compounds represented by the following formulas: 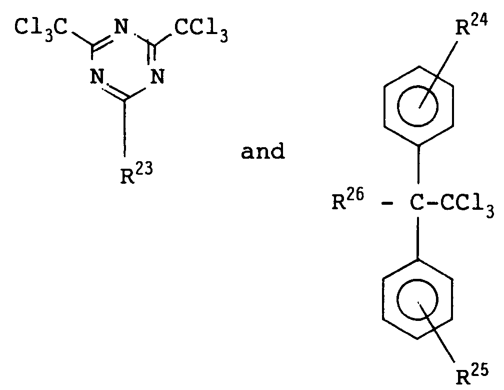 wherein R²³ represents a trichloromethyl group, a phenyl group, a methoxyphenyl group, a naphthyl group or a methoxynaphthyl group; and R²⁴, R²⁵ and R²⁶, which may be the same or different, represent hydrogen atoms, halogen atoms, alkyl groups having 1-4 carbon atoms, alkoxy groups having 1-4 carbon atoms or hydroxyl groups.
(3) o-Quinonedizide compounds represented by the following formula: 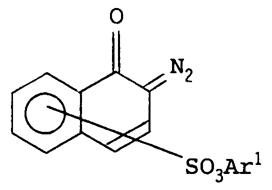 wherein Ar¹ represents 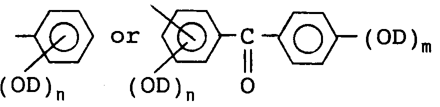 in which D is a hydrogen atom or a quinonediazidesulfonyl group and m and n are integers of 0-3,
   and the following formula: 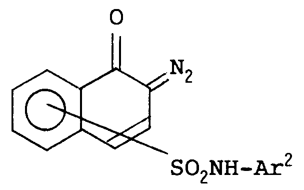 wherein Ar² represents 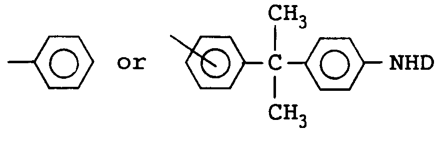 in which D is a hydrogen atom or a quinonediazide-sulfonyl group.
(4) Nitrobenzyl compounds represented by the following formula: 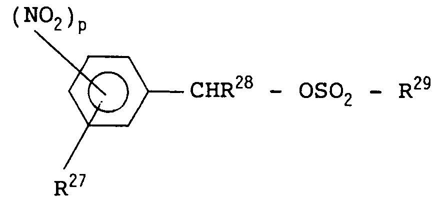 wherein R²⁷ represents an alkyl group having 1-4 carbon atoms; p represents an integer of 1-3; R²⁸ represents a hydrogen atom or a methyl group; and R²⁹ represents 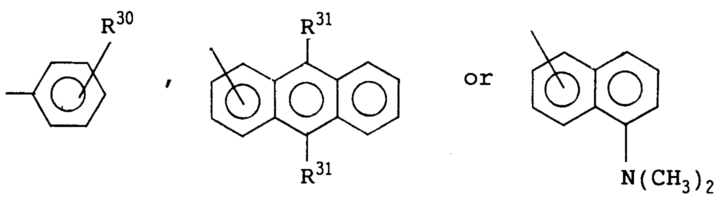 in which R³⁰ is a hydrogen atom or an alkyl group having 1-4 carbon atoms and R³¹ is an alkoxy group having 1-4 carbon atoms.
(5) Sulfonic acid ester compounds represented by the following formula: 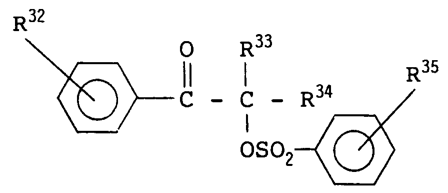 wherein R³² and R³⁵, which may be the same or different, represent hydrogen atoms or alkyl groups having 1-4 carbon atoms; and R³³ and R³⁴, which may be the same or different, represent hydrogen atoms, alkyl groups having 1-4 carbon atoms, substituted or unsubstituted aryl groups having 6-20 carbon atoms or substituted or unsubstituted aralkyl groups having 7-20 carbon atoms, the following formula: 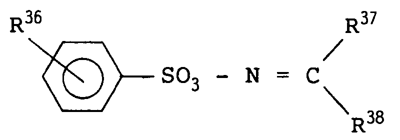 wherein R³⁶ represents a hydrogen atom or an alkyl group having 1-4 carbon atoms; R³⁷ and R³⁸, which may be the same or different, represent alkyl groups having 1-4 carbon atoms or substituted or unsubstituted aryl groups having 6-20 carbon atoms, provided they may be bonded to each other to form a ring,
   and the following formula: 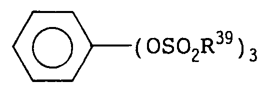 wherein R³⁹ represents a methyl group, a trichloromethyl group, a trifluoromethyl group, a phenyl group, a tolyl group, a cyanophenyl group, a trichlorophenyl group or a trifluoromethylphenyl group.
(6) Sulfone compounds represented by the following formula: 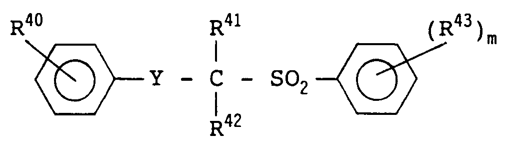 wherein Y represents 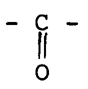 or -SO₂-; R⁴⁰, R⁴¹, R⁴² and R⁴³, which may be the same or different, represent alkyl groups having 1-4 carbon atoms, substituted or unsubstituted aralkyl groups having 7-20 carbon atoms or halogen atoms; and m represents an integer of 0-3.

Among these radiation-sensitive acid-forming agents, the onium salts are preferred, and particularly preferable are triphenylsulfonium trifluoroacetate, triphenylsulfonium trifluoromethanesulfonate, diphenyliodonium 1-pyrenylsulfonate, diphenyliodonium 4-diphenylaminosulfonate and diphenyliodonium 9,10-diethoxyanthracene-2-sulfonate. The above radiation-sensitive acid-forming agents may be used alone or in admixture.

The amount of the radiation-sensitive acid-forming agent used is preferably 0.1-20 parts by weight, more preferably 0.5-10 parts by weight, per 100 parts by weight of the silyl group-containing polymer. When it is less than 0.1 part by weight, there is a tendency that the sensitivity is reduced, while when it exceeds 20 parts by weight, there is a tendency that the developability is deteriorated.

The weakly basic, nitrogen-containing compound is a compound represented by formula (i) or a compound having at least one structure selected from those represented by formulas (ii) to (v) in its molecule: 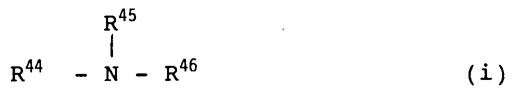
wherein R⁴⁴, R⁴⁵ and R⁴⁶, which may be the same or different, represent hydrogen atoms, alkyl groups having 1-6 carbon atoms, aminoalkyl groups having 1-6 carbon atoms, hydroxyalkyl groups having 1-6 carbon atoms or substituted or unsubstituted aryl groups having 6-20 carbon atoms, provided that R⁴⁵ and R⁴⁶ may be bonded to each other to form a ring: 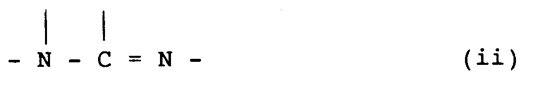 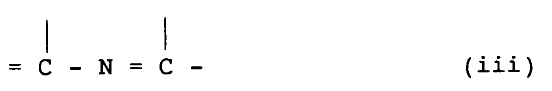 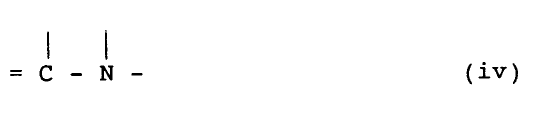 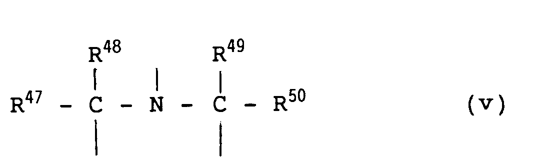
wherein R⁴⁷, R⁴⁸, R⁴⁹ and R⁵⁰, which may be the same or different, represent alkyl groups having 1-6 carbon atoms.

Specific examples of the compound represented by formula (i) include ammonia, triethylamine, tripropylamine, tributylamine, aniline, N-methylaniline, N,N-dimethylaniline, 2-methylaniline, 3-methylaniline, 4-methylaniline, 4-nitroaniline, 1-naphthylamine, 2-naphthylamine, diphenylamine, ethylenediamine, tetramethylenediamine, hexamethylenediamine, pyrrolidine, piperidine and the like.

Specific examples of the compound having the structure represented by formula (ii) in its molecule include imidazole, 4-methylimidazole, 4-methyl-2-phenylimidazole, thiabendazole and the like; specific examples of the compound having the structure represented by formula (iii) in its molecule include pyridine, 2-methylpyridine, 4-ethylpyridine, 1-methyl-4-phenylpyridine, 2-(1-ethylpropyl)pyridine, nicotinamide, dibenzoylthiamine, riboflavine tetrabutyrate and the like; specific examples of the compound having the structure represented by formula (iv) in its molecule includes 4,4′-diaminodiphenylmethane, 4,4′-diaminodiphenyl ether, 3,4′-diaminodiphenyl ether, 4,4′-diaminobenzophenone, 4,4′-diaminodiphenylamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, 1,3-bis[1-(4-aminophenyl)-1-methylethyl]benzene and the like; specific examples of the compound having the structure represented by formula (v) in its molecule include dimethyl succinate-1-(2-hydroxyethyl)-4-hydroxy-2,2,6,6-tetramethylpiperidine polycondensate, poly{[6-(1,1,3,3-tetramethylbutyl)imino-1,3,5-triazine-2,4-diyl][(2,2,6,6-tetramethyl-4-piperidyl)imino]hexamethylene[(2,2,6,6-tetramethyl-4-piperidyl)imino]}, bis(1,2,2,6,6-pentamethyl-4-piperidyl)2-(3,5-di-t-butyl-4-hydroxybenzyl)-2-n-butylmalonate and the like.

Preferable examples of the weakly basic, nitrogen-containing compound include aniline, N-methylaniline, N,N-dimethylaniline, 4-metylaniline, diphenylamine and piperidine which belong to formula (i); thiabendazole which has a structure of formula (ii) in the molecule; nicotinamide, dibenzoylthiamine, riboflavine tetrabutyrate and 2-(1-ethylpropylpyridine) which have a structure of formula (iii) in the molecule; 4,4′-diaminodiphenylmethane, 4,4′-diaminodiophenyl ether and imidazole which have a structure of formula (iv) in the molecule; and bis(1,2,2,6,6-pentamethyl-4-piperidyl) 2-(3,5-di-t-butyl-4-hydroxybenzyl)-2-n-butylmalonate which has a structure of formula (v) in the molecule.

These weakly basic, nitrogen-containing compounds may be used alone or in admixture.

The amount of the weakly basic, nitrogen-containing compound used is preferably 0.001-10 parts by weight, more preferably 0.01-5 parts by weight, per 100 parts by weight of the silyl group-containing polymer, and when it is less than 0.001 part by weight, there is a tendency that the pattern form and adhesiveness become unsatisfactory while when it exceeds 10 parts by weight, there is a tendency that the sensitivity is lowered and the developability of unexposed portions becomes unsatisfactory.

The composition of this invention comprises the silyl group-containing polymer, the radiation-sensitive acid-forming agent and the weakly basic, nitrogen-containing compound as the main components and may also have compounded therewith various additives as necessary.

The additives include, for example, surface active agents for improving the coatability, developability and the like. The surface active agents include nonionic surfactants such as polyoxyethylene lauryl ether, polyoxyethylene stearyl ether, polyoxyethylene oleyl ether, polyoxyethylene octylphenol ether, polyoxyethylene nonylphenol ether, polyethylene glycol dilaurate, polyethylene glycol distearate and the like; fluorine-containing surfactants such as F Top EF 301, EF 303 and EF 352 (products of Shin Akita Kasei K.K.), Megafac F 171 and F 173 (products of DAINIPPON INK & CHEMICALS), Fluorad FC 430 and FC 431 (products of Sumitomo 3M Limited), Asahi Guard AG 710, Surflon S-382, SC 101, SC 102, SC 103, SC 104, SC 105 and SC 106 (products of Asahi Glass Co., Ltd.) and the like; organosiloxane polymer KP 341 (product of Shin-Etsu Chemical Co., Ltd.); and Polyflow No. 75 and No. 95 (products of Kyoeisha Yushikagaku Kogyo K.K.) which are acrylic or methacrylic acid polymers; and the like.

The amount of the surface active agents used is preferably 2 parts by weight or less per 100 parts by weight of a total of the silyl group-containing polymer, the radiation-sensitive acid-forming agent and the weakly basic, nitrogen-containing compound.

The other additives include halation-preventing agent, adhering aid, storage-stabilizer, defoaming agent and the like.

The composition of this invention can be prepared by dissolving in a solvent the necessary amounts of the silyl group-containing polymer, the radiation-sensitive, acid-forming agent, the weakly basic, nitrogen-containing compound and optional various additives to prepare a solution having a solid concentration of, for example, 5-50% by weight, and then usually filtering the solution through a filter having a pore diameter of, for example, about 0.2 µm. The thus prepared composition is used.

The solvent used in this case includes, for example, ethylene glycol monomethyl ether, ethylene glycol monoethyl ether, ethylene glycol monopropyl ether, ethylene glycol monobutyl ether, diethylene glycol dimethyl ether, diethylene glycol diethyl ether, diethylene glycol dipropyl ether, diethylene glycol dibutyl ether, methyl Cellosolve acetate, ethyl Cellosolve acetate, propylene glycol monomethyl ether acetate, propylene glycol monoethyl ether acetate, propylene glycol monopropyl ether acetate, toluene, xylene, methyl ethyl ketone, cyclohexanone, methyl 2-hydroxypropionate, ethyl 2-hydroxypropionate, ethyl 2-hydroxy-2-methylpropionate, ethyl ethoxyacetate, ethyl hydroxyacetate, methyl 2-hydroxy-3-methylbutanoate, 3-methoxybutyl acetate, 3-methyl-3-methoxybutyl acetate, 3-methyl-3-methoxybutyl propionate, 3-methyl-3-methoxybutyl butyrate, ethyl acetate, butyl acetate, methyl acetoacetate, ethyl acetoacetate, methyl 3-methoxypropionate, ethyl 3-ethoxypropionate, N-methylpyrrolidone, N,N-dimethylformamide, N,N-dimethylacetamide and the like.

To the above solvent may be added, if necessary, a high-boiling solvent such as benzyl ethyl ether, dihexyl ether, diethylene glycol monomethyl ether, diethylene glycol monoethyl ether, acetonylacetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, phenyl Cellosolve acetate or the like.

The composition of this invention is coated in the form of the above-mentioned solution on a substrate such as silicon wafer or the like and dried to form a resist film. In this case, the coating on a substrate is conducted by spin-coating, flow-coating, roll-coating or the like.

The resist film formed is partially irradiated with a radiation for forming a fine pattern. The radiation used is not critical; however, for example, far ultraviolet rays such as excimer laser or the like; X-rays such as synchrotron radiation or the like; or charged particle beams such as electron beam or the like are used depending upon the kind of the radiation-sensitive acid-forming compound used.

In this invention, in order to enhance the apparent sensitivity of the resist film, it is suitable to heat the resist film after the irradiation. The heating temperature may be varied depending upon the compounding recipe and the kind of additive, and ranges usually from 30° to 200°C, preferably 50° to 150°C.

As a developing solution for the subsequent development, there may be used an aqueous alkaline solution prepared by dissolving in water sodium hydroxide, potassium hydroxide, sodium carbonate, sodium silicate, sodium metasilicate, ammonia water, ethylamine, n-propylamine, diethylamine, di-n-propylamine, triethylamine, methyldiethylamine, dimethylethanolamine, triethanolamine, tetramethylammonium hydroxide, tetraethylammonium hydroxide, pyrrol, piperidine, choline, 1,8-diazabicyclo[5.4.0]-7-undecene, 1,5-diazabicyclo[4.3.0]-5-nonane or the like.

The above alkaline solution as a developing solution may have added thereto a water-soluble organic solvent, for example, an alcohol such as methanol, ethanol or the like and a surface active agent in appropriate amounts.

After the development with the above aqueous alkaline solution, the resist film is rinsed with water and then dried.

This invention is explained in more detail below referring to Examples, which are not by way of limitation but by way of illustration. In the Examples, various characteristics were evaluated as follows.

### Developability

The amount of scum after development and the proportion of the undeveloped portion were determined using a scanning type electron microscope.

### Pattern form

The lower side length (A) and the upper side length (B) of the tetragonal cross-section of a resist pattern were measured using a scanning type electron microscope, and when 0.85 ≦ B/A ≦ 1 the pattern form was judged to be good, provided that when the cross-section trails or is inversely tapered, the pattern form was judged to be bad even if the B/A ratio falls in said range.

### Adhesiveness

The degree of stripping of resist pattern was observed using a scanning type electron microscope.

### Mw

Using GPC column manufactured by Toso K.K. (two G2000H_{XL} columns, one G3000H_{XL} column and one G4000H_{XL} column), Mw was determined by a gel permeation chromatography using a monodisperse polystyrene as a standard under such analytical conditions that the flow rate is 1.0 ml/minute, the eluant is tetrahydrofuran and the column temperature is 40°C.

### Example 1

In dioxane, 120 g of poly(4-hydroxystyrene) (Mw=25,000) was reacted with trimethylchlorosilane in the presence of 70 g of imidazole at 30°C for 4 hours. The reaction mixture was dropwise added to water and the silyl group-containing polymer separated was subjected to ¹H-NMR measurement. As a result, the proportion of the recurring structure unit represented by formula (I) was 55 mole %. In 80 g of ethyl 2-hydroxypropionate were dissolved 20 g of the polymer thus obtained, 1 g of diphenyliodonium 9,10-diethoxyanthracene-2-sulfonate and 0.5 g of 4-methylaniline, and the resulting solution was filtered through a filter having a pore diameter of 0.2 µm to obtain a composition solution.

The composition solution thus obtained was spin-coated on a silicon wafer and then baked at 90°C for 3 minutes to obtain a resist film having a thickness of 1.0 µm.

A pattern mask was intimately contacted with the resist film and the resulting assembly was irradiated through the mask with a light having a wave length of 254 nm from a 15-W low pressure mercury lamp for 2 minutes, after which the resist film separated from the pattern mask was baked at 100°C for 2 minutes, then developed with an aqueous tetramethylammonium hydroxide solution for 120 seconds (the exposed portions were dissolved and removed), and subsequently rinsed with water for 30 seconds.

As a result, a positive pattern having a line-and-line space of 0.4 µm was obtained in the state that its pattern form was good. Also, no swelling with the developing solution was observed and the developability and adhesiveness were good.

### Example 2

In dioxane, 39 g of poly(α-methyl-4-hydroxystyrene) (Mw=40,000) was reacted with ethyldimethylchlorosilane in the presence of 21 g of imidazole at 30°C for 4 hours. The reaction mixture was dropwise added to water and the silyl group-containing polymer thus separated was dried at 40°C overnight in a vacuum drier. The polymer thus obtained was subjected to ¹H-NMR measurement. As a result, the proportion of the recurring structure unit represented by formula (I) was 45 mole %. In 80 g of ethyl 2-hydroxypropionate were dissolved 20 g of the polymer thus obtained, 1 g of triphenylsulfonium trifluoromethansulfonate and 0.05 g of 4,4′-diaminodiphenylmethane, and the resulting solution was filtered through a filter having a pore diameter of 0.2 µm to obtain a composition solution.

The composition solution thus obtained was spin-coated on a silicon wafer and then baked at 90°C for 3 minutes to form a resist film having a thickness of 1.0 µm.

A pattern mask was intimately contacted with the resist film thus formed and irradiated through the mask with KrF excimer laser having a wave length of 248 nm at a dose of 20 mJ/cm², after which the resist film separated from the pattern mask was subjected to baking after irradiation, development and rinsing in the same manner as in Example 1, whereby a positive pattern having a line-and-line space of 0.4 µm was obtained in the state that its pattern form was good. Also, no swelling with the developing solution was observed and the developability and adhesiveness were good.

### Example 3

In dioxane, 24 g of a copolymer of 4-hydroxystyrene (A) and α-methylstyrene (B) ((A):(B)=9:1 by weight and Mw=25,000) was reacted with hexamethyldisilazane at 90°C for 4 hours. The reaction mixture thus obtained was dropwise added to water, and the silyl group-containing polymer thus separated was subjected to ¹H-NMR measurement. As a result, the proportion of the recurring structure unit represented by formula (I) was 60 mole %. In 80 g of ethyl 2-hydroxypropionate were dissolved 20 g of the polymer thus obtained, 1 g of triphenylsulfonium trifluoromethanesulfonate and 0.1 g of 2-(1-ethylpropyl)pyridine, and the resulting solution was filtered through a filter having a pore diameter of 0.2 µm to obtain a composition solution.

The composition solution thus obtained was spin-coated on a silicon wafer and then baked at 90°C for 3 minutes to form a resist film having a thickness of 1.0 µm.

A pattern was drawn by an electron beam of 3 µC/cm² (beam diameter = 0.25 µm) on the resist film thus formed, after which the resist film was subjected to baking after irradiation, development and rinsing in the same manner as in Example 1, whereby a positive pattern having a line-and-line space of 0.4 µm was obtained in the state that its pattern form was good. Also, no swelling with developing solution was observed and the developability and adhesiveness were good.

### Example 4

A pattern mask was intimately contacted with the resist film formed in the same manner as in Example 1, and the resulting assembly was subjected to irradiation with X-rays at a dose of 100 mJ/cm², after which the resist film separated from the pattern mask was subjected to baking after irradiation, development and rinsing in the same manner as in Example 1, whereby a positive pattern having a line-and-line space of 0.5 µm was obtained in the state that its pattern form was good. Also, no swelling with developing solution was observed and the developability and adhesiveness were good.

### Example 5

In 80 g of methyl 3-methoxypropionate were dissolved 20 g of the silyl group-containing polymer synthesized in Example 1, 0.6 g of triphenylsulfonium trifluoromethanesulfonate and 0.05 g of nicotinamide, and the resulting solution was filtered through a filter having a pore diameter of 0.2 µm to obtain a composition solution.

The composition solution thus obtained was spin-coated on a silicon wafer, and the resulting assembly was baked at 100°C for 2 minutes to form a resist film having a thickness of 1.0 µm.

The resist film thus obtained was irradiated with KrF excimer laser having a wave length of 248 nm at a dose of 60 mJ/cm² using a stepper, then baked at 90°C for 2 minutes, develped with an aqueous tetramethylammonium hydroxide solution at 23°C for 60 seconds, and thereafter rinsed with water for 30 seconds, after which the pattern thus formed was observed through a scanning type electron microscope to find that a positive pattern having a line-and-line space of 0.28 µm was formed in the state that its pattern form was good. Also, no swelling with developing solution was observed and the developability and adhesiveness were good. Even when the time of from exposure to baking was extended to 6 hours the pattern form was not changed.

### Example 6

The same procedure as in Example 5 was repeated, except that 0.1 g of thiabendazole was substituted for the 0.05 g of nicotinamide to prepare a composition solution, and a pattern was formed therefrom in the same manner as in Example 5. The pattern was observed through a scanning type electron microscope to find that a positive pattern having a line-and-line space of 0.28 µm was obtained in the state that its pattern form was good. Also, no swelling with developing solution was observed and the developability and adhesiveness were good.

### Example 7

The same procedure as in Example 5 was repeated, except that 0.04 g of dibenzoylthiamine was substituted for the 0.05 g of nicotinamide, to prepare a composition solution, and a resist pattern was formed therefrom in the same manner as in Example 5. The resist pattern formed was observed through a scanning type electron microscope to find that a positive pattern having a line-and-line space of 0.28 µm was obtained in the state that its pattern form was good. Also, no swelling with developing solution was observed and the developability and adhesiveness were good.

### Example 8

The same procedure as in Example 5 was repeated, except that 0.1 g of bis(1,2,2,6,6-pentamethyl-4-piperidyl) 2-(3,5-di-t-butyl-4-hydroxybenzyl)-2-n-butylmalonate (TINUVIN 144, a product of Ciba-Geigy Corp.) was substituted for the 0.05 g of nicotinamide, to prepare a composition solution, and a resist pattern was formed therefrom in the same manner as in Example 5. The pattern formed was observed through a scanning type electron microscope to find that a positive pattern having a line-and-line space of 0.28 µm was formed in the state that its pattern form was good. Also, no swelling with developing solution was observed and the developability and adhesiveness were good.

### Example 9

In 300 g of dioxane was dissolved 54 g (0.45 mole) of poly(4-hydroxystyrene), and hexamethyldisilzane was added to the resulting solution, after which the resulting mixture was subjected to reaction under reflux for 6 hours. After completion of the reaction, the solution was dropwise added to water, and the silyl group-containing polymer separated was dried at 40°C overnight in a vacuum drier. The silyl group-containing polymer thus obtained had a Mw of 65,000, and it was found from the result of NMR measurement that the polymer had the structure that 65% of the phenolic hydroxyl group was substituted by trimethylsilyloxy group (formula (I)/formula (III)=65/35 by mole).

In 31.2 g of methyl 3-methoxypropionate were dissolved 10 g of the silyl group-containing polymer thus obtained, 0.4 g of diphenyliodonium diphenylaminosulfonate and 0.05 g of N,N-dimethylaniline, and the resulting solution was filtered through a filter having a pore diameter of 0.2 µm to obtain a composition solution. The composition solution thus obtained was coated on a silicon wafer and then baked at 110°C for 2 minutes to form a resist film having a thickness of 1.0 µm.

A pattern mask was intimately contacted with the resist film thus formed, and the resulting assembly was irradiated through the mask with KrF excimer laser having a wave length of 248 nm at a dose of 30 mJ/cm², after which the resist film separated from the mask was baked at 80°C for 2 minutes, developed with an aqueous tetramethylammonium hydroxide solution at 25°C for 60 seconds, and then rinsed with water for 30 seconds. As a result, a positive pattern having a line-and-line space of 0.4 µm was obtained. The cross-section of this resist pattern had a rectangular form and when the resist pattern was heated on a hot plate at 130°C for 2 minutes, no change of pattern form was observed.

### Example 10

In dioxane, 24 g of poly(4-hydroxystyrene) was reacted with trimethylchlorosilane in the presence of 14 g of imidazole at 30°C for 4 hours. The reaction mixture was dropwise added to water, and the silyl group-containing polymer separated was dried at 40°C overnight. The silyl group-containing polymer obtained had a Mw of 65,000 and it was found from the result of NMR measurement that the polymer had the structure that 65% of the phenolic hydroxyl group was substituted by trimethylsilyloxy group (formula (I)/formula (III)=65/35 by mole). In 80 g of diethylene glycol dimethyl ether were dissolved 20 g of the silyl group-containing polymer thus obtained, 1 g of diphenyliodonium 9,10-diethoxyanthracene-2-sulfonate and 0.1 g of imidazole, and the resulting solution was filtered through a filter having a pore diameter of 0.2 µm to obtain a composition solution. The composition solution thus obtained was spin-coated on a silicon wafer and baked at 90°C for 3 minutes to form a resist film having a thickness of 1.0 µm.

A mask pattern was intimately contacted with the resist pattern formed and the resulting assembly was irradiated through the mask with light having a wave length of 254 nm from a 15-W low pressure mercury lamp for 2 minutes, after which the resist film separated from the pattern mask was baked at 100°C for 2 minutes, developed with an aqueous tetramethylammonium hydroxide solution for 60 seconds, and then rinsed with water. As a result, the cross-section of this resist pattern was found to be rectangular by SEM observation, and when this resist pattern was heated on a hot plate at 130°C, no change of pattern form was observed.

### Example 11

In dioxane, 26 g of poly(α-methyl-4-hydroxystyrene) was reacted with ethyldimethylchlorosilane in the presence of 14 g of imidazole at 30°C for 4 hours. The reaction mixture was dropwise added to water and the silyl group-containing polymer separated was dried at 40°C overnight in a vacuum drier. The silyl group-containing polymer thus obtained had a Mw of 50,000 and it was found from the result of NMR measurement that the polymer had the structure that 60% of the phenolic hydroxyl group was substituted by ethyldimethylsilyloxy group (formula (I)/formula (III)=60/40 by mole). In 80 g of ethyl 2-hydroxypropionate were dissolved 20 g of the silyl group-containing polymer thus obtained, 1 g of diphenyliodonium pyrenylsulfonate and 0.05 g of piperidine, and the resulting solution was filtered through a filter having a pore diameter of 0.2 µm to obtain a composition solution. The composition solution thus obtained was spin-coated on a silicon wafer, and baked at 90°C for 3 minutes to form a resist film having a thickness of 1.0 µm.

A pattern mask was intimately contacted with the resist film formed and the resulting assembly was irradiated through the mask with KrF excimer laser having a wave length of 248 nm at a dose of 20 mJ/cm², after which the resist film.separated from the pattern mask was subjected to baking after irradiation, development and rinsing in the same manner as in Example 9 to obtain a positive pattern having a line-and-line space of 0.4 µm. The cross-section of the resist pattern was found to be rectangular by SEM observation. When this resist pattern was heated on a hot plate at 130°C for 2 minutes, no change of pattern form was observed.

### Example 12

In dioxane, 24 g of a copolymer of 4-hydroxystyrene (A) and styrene (B) (A:B=9:1 by mole) was reacted with hexamethyldisilazane at 90°C for 4 hours. The reaction mixture was dropwise added to water, and the silyl group-containing polymer separated was dried at 40°C overnight in a vacuum drier. The silyl group-containing polymer thus obtained had a Mw of 30,000, and it was found from the result of NMR measurement that the polymer had the structure that 67% of the phenolic hydroxyl group was substituted by trimethylsilyloxy group (formula (I)/formula (III)=67/33 by mole). In 80 g of ethyl 2-hydroxypropionate were dissolved 20 g of the silyl group-containing polymer thus obtained, 1 g of triphenylsulfonium trifluoromethanesulfonate and 0.07 g of triethylamine, and the resulting solution was filtered through a filter having a pore diameter of 0.2 µm to obtain a composition solution. The composition solution thus obtained was spin-coated on a silicon wafer and then baked at 90°C for 3 minutes to form a resist film having a thickness of 1.0 µm. A pattern was drawn on the resist film by an electron beam of 3 µC/cm² (beam diameter: 0.25 µm), and subjected to baking after irradiation, development and rinsing in the same manner as in Example 9. As a result, a positive pattern having a line-and-line space of 0.5 µm was obtained. The cross-section of this resist pattern was found to be rectangular by SEM observation, and when this resist pattern was heated on a hot plate at 130°C for 2 minutes, no change of the pattern form was observed.

### Comparative Example 1

The same procedure as in Example 1 was repeated, except that the 4-methylaniline was not added, to prepare a composition solution, and the same evaluations as in Example 1 were conducted using the composition solution thus obtained to find that the positive pattern having a line-and-line space of 0.4 µm had an inversely tapered form (B/A=3), and that two of the five pattern lines were stripped.

### Comparative Example 2

The same procedure as in Example 2 was repeated, except that the 4,4′-diaminodiphenylmethane was not added, to prepare a composition solution, and the same evaluations as in Example 2 were conducted using the composition solution thus obtained to find that a positive pattern having a line-and-line space of 0.4 µm had an inversly tapered form (B/A=2) and that one of the five pattern lines was stripped and undeveloped portions were left.

### Comparative Example 3

The same procedure as in example 5 was repeated, except that the nicotinamide was not added, to prepare a composition solution, and the same evaluations as in Example 5 were conducted using the composition solution thus obtained to find that when the pattern film was irradiated at a dose of 5 mJ/cm² a pattern having a line-and-line space of 0.35 µm was obtained; however, the cross-section of the pattern was such that the upper side of the cross-section of the pattern had a visor. When the time of from exposure to baking after exposure was extended to 6 hours, an insoluble layer was formed on the surface of the resist film and it was impossible to obtain a pattern.

The radiation-sensitive composition of this invention is suitable as a resist composition capable of responding to various radiations such as far ultraviolet rays such as excimer laser or the like, X-rays such as synchrotron radiations or the like or charged particle beams such as electron beam or the like, and the resist film formed from the radiation-sensitive composition is not swollen with a developing solution, is excellent in developability, pattern form, adhesiveness, lithographic process stability and heat resistance, and has high resolution degree and high sensitivity.

## Claims

1. A radiation-sensitive composition comprising a polymer having acid-decomposable silyl groups, a radiation-sensitive acid-forming agent and a weakly basic, nitrogen-containing compound.

2. The radiation-sensitive composition according to Claim 1, wherein the polymer consists essentially of a recurring structure unit represented by formula (I) or a combination thereof with at least one recurring structure unit selected from those represented by formulas (II)(a), (II)(b) and (II)(c) and those corresponding to the structures formed by splitting the vinyl group of maleic anhydride, vinylpyridine, vinylpyrrolidone, vinylimidazole, vinylaniline, fumaronitrile, acrylamide and acrylonitrile: 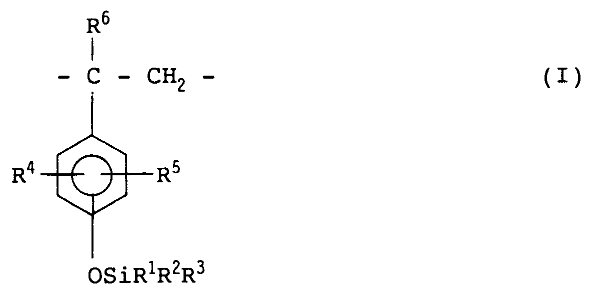 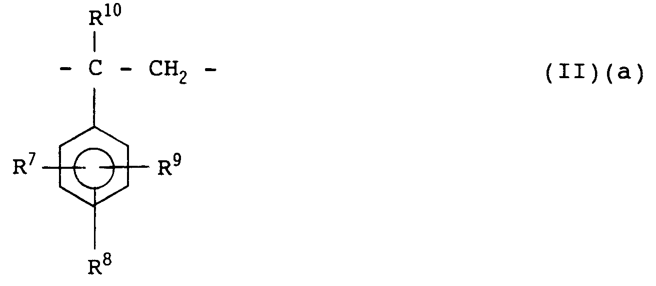 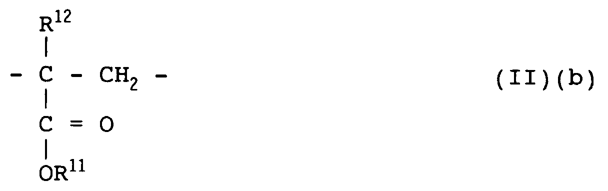 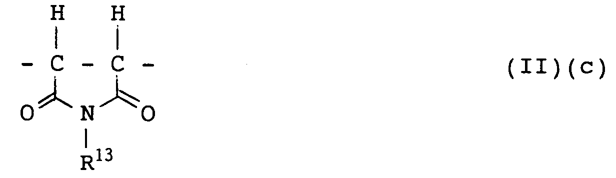 wherein R¹ , R² and R³, which may be the same or different, represent hydrogen atoms, alkyl groups having 1-4 carbon atoms, phenyl groups or benzyl groups; R⁴ and R⁵, which may be the same or different, represent hydrogen atoms, halogen atoms, hydroxyl groups or alkyl groups having 1-4 carbon atoms; R⁶ represents a hydrogen atom or a methyl group; R⁷, R⁸ and R⁹, which may be the same or different, represent hydrogen atoms, halogen atoms, hydroxyl groups, amino groups, alkyl groups having 1-4 carbon atoms or alkoxy groups having 1-4 carbon atoms; R¹⁰ represents a hydrogen atom or a methyl group; R¹¹ represents an alkyl group having 1-4 carbon atoms; R¹² represents a hydrogen atom or a methyl group; and R¹³ represents a hydrogen atom,.a phenyl group or a hydroxyphenyl group.

3. The radiation-sensitive composition according to Claim 2, wherein the polymer consists essentially of a recurring structure unit represented by formula (I) and a recurring structure unit represented by formula (II)(a).

4. The radiation-sensitive composition according to Claim 3, wherein the recurring structure unit represented by formula (II)(a) is that represented by formula (III): 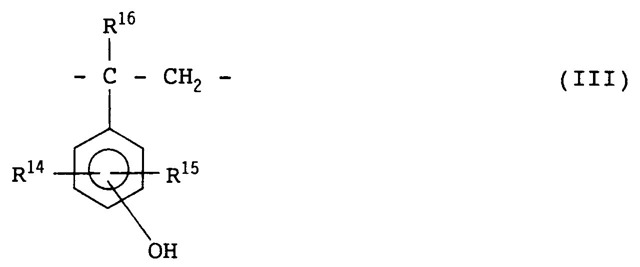 wherein R¹⁴ and R¹⁵, which may be the same or different, represent hydrogen atoms, halogen atoms or alkyl groups having 1-4 carbon atoms; and R¹⁶ represents a hydrogen atom or a methyl group.

5. The radiation-sensitive composition according to Claim 1, wherein the radiation-sensitive acid-forming agent is at least one member selected from the group consisting of
(1) an onium salt represented by one of the following formulas: 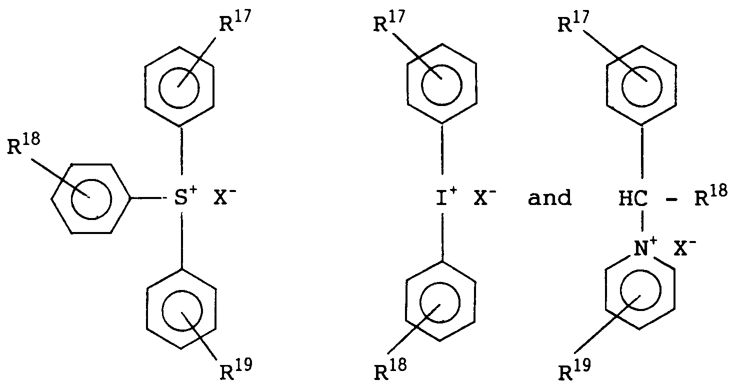 wherein R¹⁷, R¹⁸ and R¹⁹, which may be the same or different, represent hydrogen atoms, amino groups, nitro groups, cyano groups, alkyl groups having 1-4 carbon atoms or alkoxy groups having 1-4 carbon atoms; and X represents SbF₆, AsF₆, PF₆, BF₄, CF₃CO₂, ClO₄, CF₃SO₃, 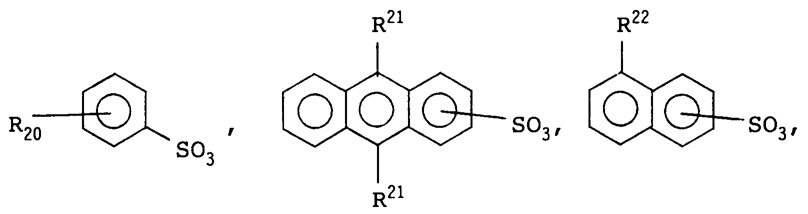 or 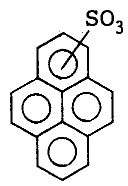 in which R²⁰ represents a hydrogen atom, an amino group, an anilino group, an alkyl group having 1-4 carbon atoms or an alkoxy group having 1-4 carbon atoms; R²¹ represents an alkoxy group having 1-4 carbon atoms; and R²² represents a hydrogen atom, an amino group, an anillino group, an alkyl group having 1-4 carbon atoms or an alkoxy group having 1-4 carbon atoms,
(2) a halogen-containing compound represented by one of the following formulas: 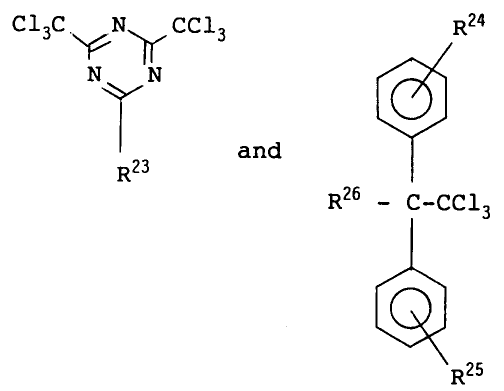 wherein R²³ represents a trichloromethyl group, a phenyl group, a methoxyphenyl group, a naphthyl group or a methoxynaphthyl group; R²⁴, R²⁵ and R²⁶, which may be the same or different, represent hydrogen atoms, halogen atoms, alkyl groups having 1-4 carbon atoms, alkoxy groups having 1-4 carbon atoms or hydroxyl groups,
(3) an o-quinonediazide compound represented by one of the following formulas: 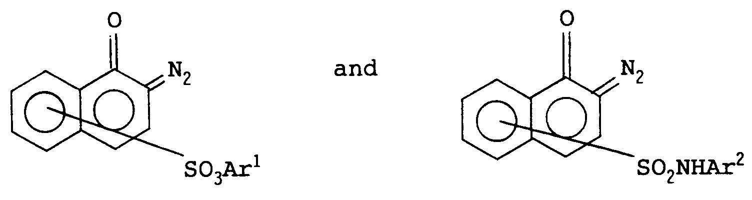 wherein Ar¹ is 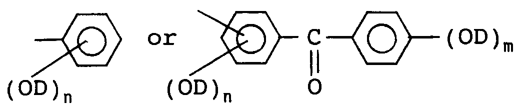 in which D is a hydrogen atom or a quinonediazidesulfonyl group and m and n are integers of 0-3; and Ar² is 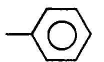 or 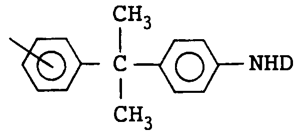 in which D is as defined above,
(4) a nitrobenzyl compound represented by the following formula: 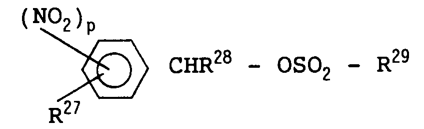 wherein R²⁷ represents an alkyl group having 1-4 carbon atoms; p represents an integer of 1-3; R²⁸ represents a hydrogen atom or a methyl group; and R²⁹ represents 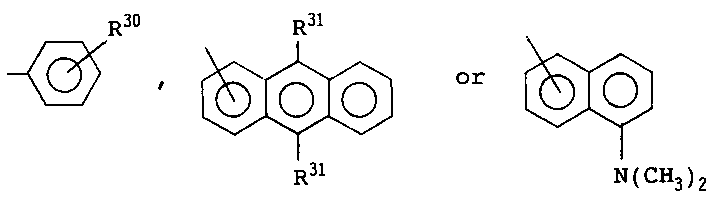 in which R³⁰ is a hydrogen atom or an alkyl group having 1-4 carbon atoms and R³¹ is an alkoxy group having 1-4 carbon atoms,
(5) a sulfonic acid ester compound represented by one of the following formulas: 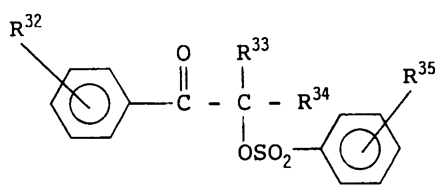 wherein R³² and R³⁵, which may be the same or different, represent hydrogen atoms or alkyl groups having 1-4 carbon atoms; R³³ and R³⁴, which may be the same or different, represent hydrogen atoms, alkyl groups having 1-4 carbon atoms, substituted or unsubstituted aryl groups having 6-20 carbon atoms or substituted or unsubstituted aralkyl groups having 7-20 carbon atoms, 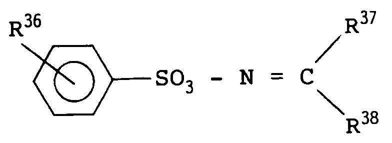 wherein R³⁶ represents a hydrogen atom or an alkyl group having 1-4 carbon atoms; R³⁷ and R³⁸, which may be the same or different, represent alkyl groups having 1-4 carbon atoms, substituted or unsubstituted aryl groups having 6-20 carbon atoms, provided they may be bonded to each other to form a ring, and 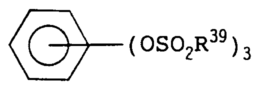 wherein R³⁹ represents a methyl group, a trichloromethyl group, a trifluoromethyl group, a phenyl group, a tolyl group, a cyanophenyl group, a trichlorophenyl group or a trifluoromethylphenyl group, and
(6) a sulfone compound represented by the following formula: 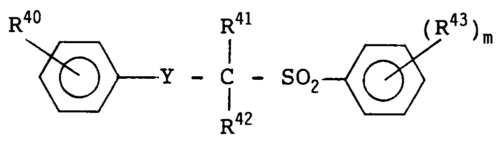 wherein Y represents 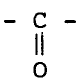 or -SO₂-; R⁴⁰, R⁴¹, R⁴² and R⁴³, which may be the same or different, represent alkyl groups having 1-4 carbon atoms, aralkyl groups having 7-20 carbon atoms or halogen atoms; and m represents an integer of 0-3.

6. The radiation-sensitive composition according to Claim 5, wherein the radiation-sensitive acid-forming agent is the onium salt.

7. The radiation-sensitive composition according to Claim 1, wherein the weakly basic, nitrogen-containing compound is at least one member selected from the group consisting of a compound represented by formula (i): 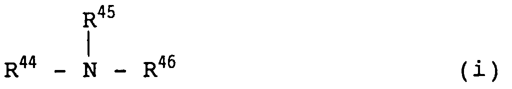 wherein R⁴⁴, R⁴⁵ and R⁴⁶, which may be the same or different, represent hydrogen atoms, alkyl groups having 1-6 carbon atoms, aminoalkyl groups having 1-6 carbon atoms, hydroxyalkyl groups having 1-6 carbon atoms or substituted or unsubstituted aryl groups having 6-20 carbon atoms, provided that R⁴⁵ and R⁴⁶ may be bonded to each other to form a ring, and a compound having at least one structure selected from those represented by formulas (ii) to (v): 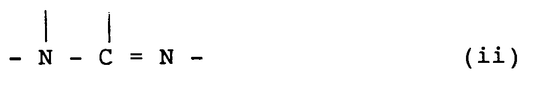 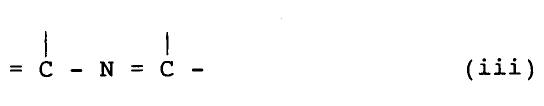 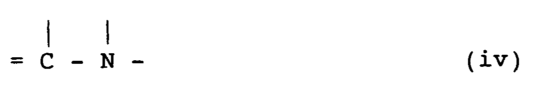 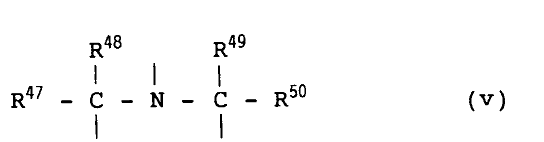 wherein R⁴⁷, R⁴⁸, R⁴⁹ and R⁵⁰, which may be the same or different, represent alkyl groups having 1-6 carbon atoms.

8. The radiation-sensitive composition according to Claim 1, wherein the weakly basic, nitrogen-containing compound is ammonia, triethylamine, tripropylamine, tributylamine, anillne, N-methylaniline, N,N-dimethylaniline, 2-methylaniline, 3-methylaniline, 4-methylaniline, 4-nitroaniline, 1-naphthylamine, 2-naphtylamine, diphenylamine, ethylenediamine, tetramethylenediamine, hexamethylenediamine, pyrrolidine or piperidine.

9. The radiation-sensitive composition according to Claim 1, wherein the weakly basic, nitrogen-containing compound is imidazole, 4-methylimidazole, 4-methyl-2-phenylimidazole or thiabendazole.

10. The radiation-sensitive composition according to Claim 1, wherein the weakly basic, nitrogen-containing compound is pyridine, 2-methylpyridine, 4-ethylpyridine, 1-methyl-4-phenylpyridine, 2-(1-ethylpropyl)pyridine, nicotinamide, dibenzoylthiamine or riboflavine tetrabutyrate.

11. The radiation-sensitive composition according to Claim 1, wherein the weakly basic, nitrogen-containing compound is 4,4′-diaminodiphenylmethane, 4,4′-diaminodiphenyl ether, 3,4′-diaminodiphenyl ether, 4,4′-diaminobenzophenone, 4,4′-diaminodiphenylamine, 2,2-bis(4-aminophenyl)propane, 2-(3-aminophenyl)-2-(4-aminophenyl)propane, 2-(4-aminophenyl)-2-(4-hydroxyphenyl)propane, 1,4-bis[1-(4-aminophenyl)-4-methylethyl]benzene or 1,3-bis[1-(4-aminophenyl)-1-methylethyl]benzene.

12. The radiation-sensitive composition according to Claim 1, wherein the weakly basic, nitrogen-containing compound is dimethyl succinate-1-(2-hydroxyethyl)-4-hydroxy-2,2,6,6-tetramethylpiperidine polycondensate, poly{[6-(1,1,3,3-tetramethylbutyl)imino-1,3,5-triazine-2,4-diyl][(2,2,6,6-tetramethyl-4-piperidyl)imino]hexamethylene[(2,2,6,6-tetramethyl-4-piperidyl)imino]} or bis (1,2,2,6,6-pentamethyl-4-piperidyl)2-(3,5-di-t-butyl-4-hydroxybenzyl)-2-n-butylmalonate.

13. The radiation-sensitive composition according to Claim 1, wherein the polymer having acid-decomposable silyl groups has a polystyrene-reduced weight average molecular weight of 10,000-300,000.

14. The radiation-sensitive composition according to Claim 2, wherein the content of the recurring structure unit represented by formula (I) is 15 mole% or more.

15. The radiation-sensitive composition according to Claim 1, wherein the radiation-sensitive acid-forming agent is contained in a proportion of 0.1-20 parts by weight per 100 parts by weight of the polymer having acid-decomposable silyl groups.

16. The radiation-sensitive composition according to Claim 1, wherein the weakly basic, nitrogen-containing compound is contained in a proportion of 0.001-10 parts by weight per 100 parts by weight of the polymer having acid-decomposable silyl groups.
